# EUROPEAN PATENT APPLICATION

(11) **EP 3 364 402 A1**
(43) Date of publication of application: **22.08.2018**
(21) Application number: 16852864.4
(22) Date of filing: 14.10.2016
(51) Int. Cl.: G09G 3/32

(54) **OLED PIXEL STRUCTURE, AND DRIVING METHOD, DRIVING CIRCUIT, AND DISPLAY APPARATUS THEREOF**

(30) Priority: 16.10.2015 CN 201510673840
(71) Applicant: BOE Technology Group Co., Ltd., Beijing 100015 (CN)
(72) Inventor: CHUNG, Chieh Hsing, Beijing 100176 (CN)
(74) Representative: Klunker IP Patentanwälte PartG mbB
(86) International application number: PCT/CN2016/102218
(87) International publication number: WO 2017/063597

(57) **Abstract**

An organic light-emitting diode (OLED) pixel structure, a driving method, a driving circuit and a display device. The pixel structure includes a plurality of pixel units arranged in a matrix; each pixel unit includes a plurality of sub-pixels with different colors (1, 11; 2, 12; 3, 13); at least two sub-pixels in each pixel unit share one compensating circuit; and different sub-pixels sharing the same one compensating circuit are respectively displayed in different periods of outputting one frame of image. The pixel structure can improve the dynamic resolution of the display device and optimize the display effect.

## Description

### TECHNICAL FIELD

Embodiments of the present disclosure relate to an organic light-emitting diode (OLED) pixel structure, a driving method, a driving circuit, and a display device.

### BACKGROUND

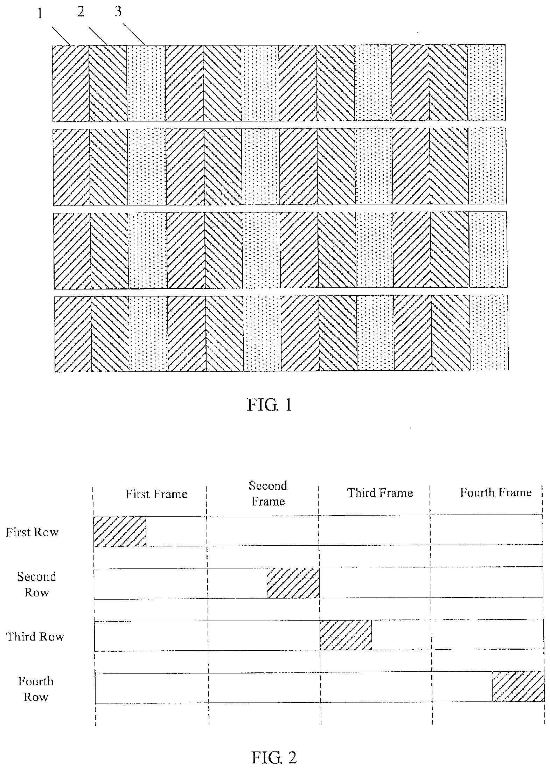

In order to solve the problem regarding the difficult in the layout of an active-matrix organic light-emitting diode (AMOLED) display device of high resolution, two sub-pixels may share one compensating circuit. As illustrated in FIG. 1, an AMOLED pixel structure comprises a plurality of pixel units, and each pixel unit may include a blue sub-pixel 1, a red sub-pixel 2 and a green sub-pixel 3. A sub-pixel in the first row and a sub-pixel at a corresponding position of the second row share one compensating circuit; a sub-pixel in the third row and a sub-pixel at a corresponding position of the fourth row share one compensating circuit; ...; and a sub-pixel in the 2k-1^{th} row and a sub-pixel at a corresponding position of the 2k^{th} row share one compensating circuit, namely sub-pixels in different pixel units share one compensating circuit. In the working process of the display device, the sub-pixels of various colors in a same pixel are simultaneously displayed; odd rows of pixel units are driven to display in the first half period of outputting one frame of image; and even rows of pixel units are driven to display in the second half period of outputting the one frame of image.

However, the display device will suffer from the problem of reduced dynamic resolution when the display device is displaying dynamic images, for instance, when a single transverse line having a width of one pixel unit is moved in each frame (e.g., the first frame of image displays the first row of pixels, and the remaining rows are in dark state; the second frame of image displays the second row of pixels, and the remaining rows are in dark state; ...). Detailed description will be given below. As illustrated in FIG. 2, in the first half period of outputting the first frame of image, the odd rows of pixel units are driven to display; in this period, the single transverse line, e.g., the first row of pixels, can be displayed, and the remaining odd rows of pixels display dark sate. In the second half period of outputting the first frame of image, the even rows of pixel units are driven to display (driven to display the dark state), but in this period, the single transverse line is disposed in the first row of pixel units, so no image can be displayed in the second half period of outputting the first frame of image (when the dark state is displayed, there is no image display for human vision). In the first half period of the second frame of image, the odd rows of pixel units are driven to display, but in this period, the single transverse line is disposed in the second row of pixel units, so no image is displayed in the first half period of outputting the second frame of image. In the second half period of outputting the second frame of image, the even rows of pixel units are driven to display, and in this period, the single transverse line can be displayed. In the first half period of outputting the third frame of image, the odd rows of pixel units are driven to display, and in this period, the single transverse line can be displayed. In the second half period of outputting the third frame of image, the even rows of pixel units are driven to display, but in this period, the single transverse line is disposed in the third rod of pixel units, so no image is displayed in the second half period of outputting the third frame of image. In the first half period of outputting the fourth frame of image, the odd rows of pixel units are driven to display, but in this period, the single transverse line is disposed in the fourth row of pixel units, so no image is displayed in the first half period of outputting the fourth frame of image. In the second half period of outputting the fourth frame of image, the even rows of pixel units are driven to display, and in this period, the single transverse line can be displayed. Thus, as illustrated in FIG. 2, the display time of the single transverse line in the first frame is separated too far away from the display time of the single transverse line in the second frame, but the display time of the single transverse line in the second frame is separated too close to the display time of the single transverse line in the third frame, so the original smooth image can provide the sense of mesh division, and hence the dynamic resolution of the display device can be reduced.

### SUMMARY

Embodiments of the present disclosure provide an OLED pixel structure, a driving method, a driving circuit, and a display device, which can improve the dynamic resolution of the display device and optimize the display effect.

An embodiment of the present disclosure provides an organic light-emitting diode (OLED) pixel structure, comprising a plurality of pixel units arranged in a matrix; each pixel unit includes a plurality of sub-pixels with different colors; at least two sub-pixels in each pixel unit share one compensating circuit; and different sub-pixels sharing the same one compensating circuit are respectively displayed in different periods of outputting one frame of image.

Further, for example, the pixel unit includes a first sub-pixel, a second sub-pixel and a third sub-pixel with different colors.

Further, for example, the first sub-pixel, the second sub-pixel and the third sub-pixel are disposed in a same row; and the first sub-pixel and the second sub-pixel share the same one compensating circuit.

Further, for example, the first sub-pixel, the second sub-pixel and the third sub-pixel are arranged in a delta shape or in an inverted delta shape; the first sub-pixel and the second sub-pixel, and the third sub-pixel are disposed in different rows; and the first sub-pixel and the third sub-pixel share the same one compensating circuit:

Further, for example, the first sub-pixel, the second sub-pixel and the third sub-pixel are respectively a red sub-pixel, a green sub-pixel and a blue sub-pixel, respectively.

Another embodiment of the present disclosure provides a driving method of any one of the above-mentioned OLED pixel structures, and the driving method includes: driving portion of sub-pixels in the pixel units to display in a first period of outputting one frame of image; and driving remaining sub-pixels in the pixel units to display in a second period of outputting the one frame of image. The first period is not overlapped with the second period; and at least one sub-pixel driven in the first period and at least one sub-pixel driven in the second period share the same one compensating circuit.

Further, for example, in the case where a first sub-pixel, a second sub-pixel and a third sub-pixel in the pixel unit are disposed in a same row, and the first sub-pixel and the second sub-pixel share the same one compensating circuit, the first sub-pixel in the pixel unit is driven to display in the first period of outputting one frame of image, and the second sub-pixel and the third sub-pixel in the pixel unit are driven to display in the second period of outputting the one frame of image; or the first sub-pixel and the third sub-pixel in the pixel unit are driven to display in the first period of outputting one frame of image, and the second sub-pixel in the pixel unit is driven to display in the second period of outputting the one frame of image.

Further, for example, in the case where a first sub-pixel, a second sub-pixel and a third sub-pixel in the pixel unit are arranged in a delta shape or in an inverted delta shape, the first sub-pixel and the second sub-pixel, and the third sub-pixel being disposed in different rows, the first sub-pixel and the third sub-pixel sharing the same one compensating circuit, the first sub-pixel and the second sub-pixel in the pixel unit are driven to display in the first period of outputting one frame of image, and the third sub-pixel in the pixel unit is driven to display in the second period of outputting the one frame of image; or the third sub-pixel in the pixel unit is driven to display in the first period of outputting one frame of image, and the first sub-pixel and the second sub-pixel in the pixel unit are driven to display in the second period of outputting the one frame of image.

Further, for example, a sum of durations of the first period and the second period is equal to duration of outputting one frame of image.

Still another embodiment of the present disclosure provides a driving circuit of any one of the above-mentioned OLED pixel structures, comprising: a first driving unit configured to drive portion of sub-pixels in the pixel units to display in the first period of outputting one frame of image; and a second driving unit configured to drive remaining sub-pixels in the pixel units to display in the second period of outputting the one frame of image; the first period is not overlapped with the second period; and at least one sub-pixel driven in the first period and at least one sub-pixel driven in the second period share the same one compensating circuit.

Further still another embodiment of the present disclosure provides a display device, comprising the above-mentioned OLED pixel structure 5 and the above-mentioned driving circuit.

### BRIEF DESCRIPTION OF THE DRAWINGS

In order to clearly illustrate the technical solution of the embodiments of the disclosure, the drawings of the embodiments will be briefly described in the following; it is obvious that the described drawings are only related to some embodiments of the disclosure and thus are not limitative of the disclosure.
FIG. 1 is a schematic diagram of an OLED pixel structure;
FIG. 2 is a schematic diagram illustrating the mesh division of an image when the OLED pixel structure displays the dynamic image;
FIG. 3 is a drive diagram when the OLED pixel structure displays an image;
FIG. 4 is a schematic diagram of an OLED pixel structure;
FIG. 5 is a drive diagram when the OLED pixel structure displays an image; and
FIG. 6 is a schematic diagram of another OLED pixel structure.

### DETAILED DESCRIPTION

In order to make objects, technical details and advantages of the embodiments of the disclosure apparent, the technical solutions of the embodiments will be described in a clearly and fully understandable way in connection with the drawings related to the embodiments of the disclosure. Apparently, the described embodiments are just a part but not all of the embodiments of the disclosure. Based on the described embodiments herein, those skilled in the art can obtain other embodiment(s), without any inventive work, which should be within the scope of the disclosure.

Unless otherwise defined, all the technical and scientific terms used herein have the same meanings as commonly understood by one of ordinary skill in the art to which the present disclosure belongs. The terms "first," "second," etc., which arc used in the description and the claims of the present application for disclosure, are not intended to indicate any sequence, amount or importance, but distinguish various components. Also, the terms such as "a," "an," etc., are not intended to limit the amount, but indicate the existence of at least one. The terms "comprise," "comprising," "include," "including," etc., are intended to specify that the elements or the objects stated before these terms encompass the elements or the objects and equivalents thereof listed after these terms, but do not preclude the other elements or objects. The phrases "connect", "connected", etc., are not intended to define a physical connection or mechanical connection, but may include an electrical connection, directly or indirectly. "On," "under," "right," "left" and the like are only used to indicate relative position relationship, and when the position of the object which is described is changed, the relative position relationship may be changed accordingly.

In order to solve the problem that an image presents the sense of mesh division when the active matrix organic light emitting diode (AMOLED) pixel structure as illustrated in FIG. 1 displays the dynamic image, embodiments of the present disclosure provide a new OLED pixel structure, a driving method, a driving circuit and a display device, which can improve the dynamic resolution of the display device and optimize the display effect.

### First Embodiment

The embodiment provides an OLED pixel structure, which comprises a plurality of pixel units arranged in a matrix. Each pixel unit includes a plurality of sub-pixels with different colors; at least two sub-pixels in each pixel unit share one compensating circuit; and different sub-pixels sharing the same one compensating circuit are respectively displayed in different periods of outputting one frame of image.

In the embodiment, different sub-pixels in a same pixel unit share a same compensating circuit, and different sub-pixels sharing the same one compensating circuit are respectively displayed in different periods of outputting one frame of image. Thus, on one hand, the embodiment can solve the problem of difficult layout of an OLED display panel of high resolution; and on the other hand, the embodiment can avoid the problem that the display time moments of two adjacent rows of pixel units are too far away from or too close to each other in the process of displaying a dynamic image, and hence can improve the dynamic resolution of the display device and optimize the display effect.

In one preferred embodiment, each pixel unit includes three sub-pixels (e.g., red, green and blue (RGB) sub-pixels), namely each pixel unit includes a first sub-pixel, a second sub-pixel and a third sub-pixel with different colors. Of course, each pixel unit is not limited to include three sub-pixels and may also include four or more sub-pixels (e.g., red, green, blue and white (RGBW) sub-pixels), as long as different sub-pixels sharing the same compensating circuit can be respectively displayed in different periods of outputting one frame of image.

In one preferred embodiment, the first sub-pixel, the second sub-pixel and the third sub-pixel may be disposed in a same row, in which the first sub-pixel and the second sub-pixel share the same compensating circuit.

In another preferred embodiment, the first sub-pixel, the second sub-pixel and the third sub-pixel may be arranged in the delta shape (Δ) or in the inverted delta (∇) shape; the first sub-pixel and the second sub-pixel are disposed in different rows from the third sub-pixel are; and the first sub-pixel and the third sub-pixel share the same compensating circuit. In the embodiment of the present disclosure, the arrangement mode of the sub-pixels is not limited to the specific form as illustrated in the figure and may adopt any appropriate arrangement mode.

For instance, in the embodiment, the first sub-pixel is one of a red sub-pixel, a green sub-pixel and a blue sub-pixel; correspondingly, the second sub-pixel is another one of the red sub-pixel, the green sub-pixel and the blue sub-pixel; and accordingly, the third sub-pixel is the third one of the red sub-pixel, the green sub-pixel and the blue sub-pixel.

### Second Embodiment

The embodiment provides a driving method of the foregoing OLED pixel structure. The driving method comprises the following operations: driving portion of sub-pixels in the pixel units to display in the first period of outputting one frame of image; and driving the remaining sub-pixels in the pixel units to display in the second period of outputting the one frame of image, wherein the first period is not overlapped with the second period, and at least one sub-pixel driven in the first period and at least one sub-pixel driven in the second period share one compensating circuit.

In the embodiment, different sub-pixels in a same pixel unit share a same compensating circuit, and different sub-pixels sharing the same one compensating circuit are respectively displayed in different periods of outputting one frame of image. Thus, on one hand, the embodiment can solve the problem of difficult layout of an OLED display panel of high resolution; and on the other hand, the embodiment can avoid the problem that the display time moments of two adjacent rows of pixel units are too far away from or too close to each other in the process of displaying a dynamic image, and hence can improve the dynamic resolution of the display device and optimize the display effect.

Moreover, for instance, in one example, when the first sub-pixel, the second sub-pixel and the third sub-pixel in the pixel unit are disposed in the same row, and the first sub-pixel and the second sub-pixel share the same compensating circuit, the driving method specifically comprises the following steps: driving the first sub-pixels in the pixel units to display in the first period of outputting one frame of image, and driving the second sub-pixels and the third sub-pixels in the pixel units to display in the second period of outputting the one frame of image; or driving the first sub-pixels and the third sub-pixels in the pixel units to display in the first period of outputting one frame of image, and driving the second sub-pixels in the pixel units to display in the second period of outputting the one frame of image.

Moreover, for instance, in one example, when the first sub-pixel, the second sub-pixel and the third sub-pixel in the pixel unit are arranged in the delta shape or in the inverted delta shape, the first sub-pixel and the second sub-pixel, and the third sub-pixel being disposed in different rows, the first sub-pixel and the third sub-pixel sharing the same compensating circuit, the driving method specifically comprises the following steps: driving the first sub-pixels and the second sub-pixels in the pixel units to display in the first period of outputting one frame of image, and driving the third sub-pixels in the pixel units to display in the second period of outputting the one frame of image; or driving the third sub-pixels in the pixel units to display in the first period of outputting one frame of image, and driving the first sub-pixels and the second sub-pixels in the pixel units to display in the second period of outputting the one frame of image.

Furthermore, for instance, the sum of the durations of the first period and the second period is equal to the duration of outputting one frame of image, so that smooth images can be guaranteed and the sense of mesh division can be avoided.

### Third Embodiment

The embodiment provides a driving circuit of the foregoing OLED pixel structure. The driving circuit comprises: a first driving unit configured to drive portion of sub-pixels in the pixel units to display in the first period of outputting one frame of image; and a second driving unit configured to drive the remaining sub-pixels in the pixel units to display in the second period of outputting the one frame of image, wherein the first period is not overlapped with the second period; and at least one sub-pixel driven in the first period and at least one sub-pixel driven in the second period share one compensating circuit. The first driving unit and the second driving unit, for instance, may be realized by an integrated circuit (IC), a semiconductor chip or the like, and for instance, may also be realized by being integrated into the same chip.

In the embodiment, different sub-pixels in a same pixel unit share the same compensating circuit, and different sub-pixels sharing the same one compensating circuit are respectively displayed in different periods of outputting one frame of image. Thus, on one hand, the embodiment can solve the problem of difficult layout of an OLED display panel of high resolution; and on the other hand, the embodiment can avoid the problem that the display time moments of two adjacent rows of pixel units are too far away from or too close to each other in the process of displaying a dynamic image, and hence can improve the dynamic resolution of the display device and optimize the display effect.

### Fourth Embodiment

The embodiment provides a display device, which comprises the foregoing OLED pixel structure and the foregoing driving circuit. The display device may be: any product or component with display function such as a TV, a display, a digital picture frame, a mobile phone and a tablet PC.

### Fifth Embodiment

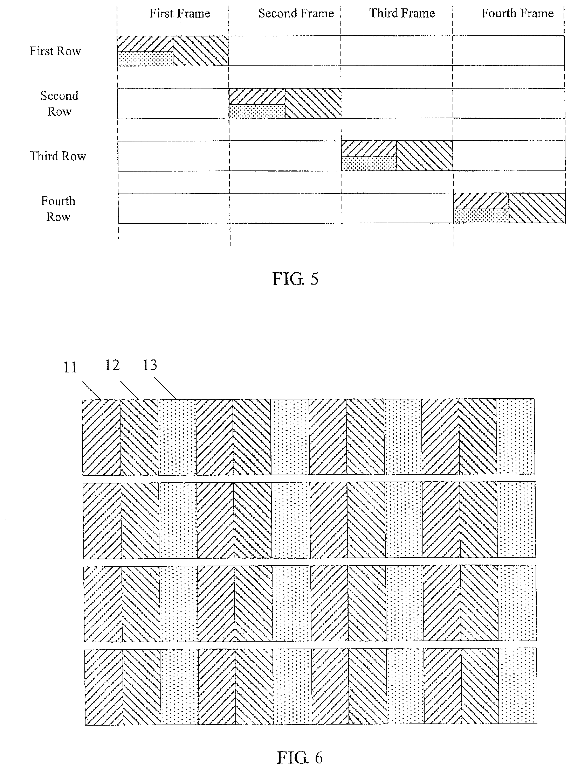

As illustrated in FIG. 6, the OLED pixel structure provided by the embodiment comprises a plurality of pixel units arranged in a matrix. Each pixel unit includes a blue sub-pixel 11, a red sub-pixel 12 and a green sub-pixel 13 disposed in the same row, in which any two sub-pixels share one compensating circuit. For instance, the blue sub-pixel 11 and the red sub-pixel 12 share one compensating circuit; or the green sub-pixel 13 and the red sub-pixel 12 share one compensating circuit; or the green sub-pixel 13 and the blue sub-pixel 11 share one compensating circuit. Thus, the problem of difficult layout of the OLED display device in the case of high resolution can be solved.

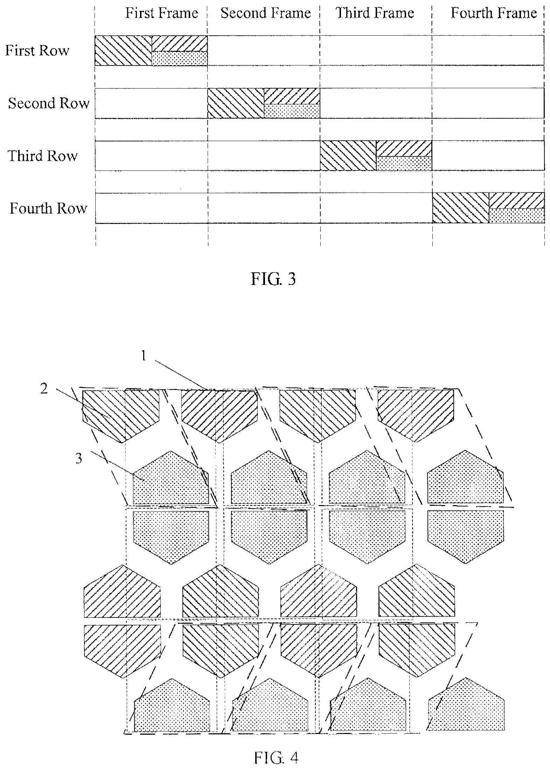

Taking the case that the red sub-pixel 12 and the blue sub-pixel 11 share one compensating circuit as an example, as illustrated in FIG. 3, when the OLED pixel structure as illustrated in FIG. 6 is driven, the red sub-pixels 12 in the pixel units are driven to display in the first period of outputting one frame of image; the green sub-pixels 13 and the blue sub-pixels 11 in the pixel units are driven to display in the second period of outputting the one frame of image; and the first period is not overlapped with the second period. In order to ensure to smoothly display images, the sum of the durations of the first period and the second period is preferably the duration of outputting one frame of image. Thus, in the process of displaying a dynamic image, the display time and the display images of two adjacent rows of pixel units can be better connected, so that the sense of mesh division can be avoided.

Moreover, in the case where the red sub-pixel 12 and the green sub-pixel 13 share one compensating circuit, as illustrated in FIG. 3, when the OLED pixel structure as illustrated in FIG. 6 is driven, the red sub-pixels 12 in the pixel units are driven to display in the first period of outputting one frame of image; the green sub-pixels 13 and the blue sub-pixels 11 in the pixel units are driven to display in the second period of outputting the one frame of image; and the first period is not overlapped with the second period. In order to ensure smooth images, the sum of the durations of the first period and the second period is equal to the duration of outputting one frame of image. Thus, in the process of displaying a dynamic image, the display time and the display images of two adjacent rows of pixel units can be better connected, so that the sense of mesh division can be avoided.

Moreover, in the case where the red sub-pixel 12 and the green sub-pixel 13 share one compensating circuit, when the OLED pixel structure as illustrated in FIG. 6 is driven, the green sub-pixels 13 in the pixel units are driven to display in the first period of outputting one frame of image; the red sub-pixels 12 and the blue sub-pixels 11 in the pixel units are driven to display in the second period of outputting the one frame of image:, and the first period is not overlapped with the second period. In order to ensure smooth images, the sum of the durations of the first period and the second period is equal to the duration of outputting one frame of image. Thus, in the process of displaying a dynamic image, the display time and the display images of two adjacent rows of pixel units can be better connected, so that the sense of mesh division can be avoided.

Moreover, in the case where the blue sub-pixel 11 and the green sub-pixel 13 share one compensating circuit, when the OLED pixel structure as illustrated in FIG. 6 is driven, the blue sub-pixels 11 in the pixel units are driven to display in the first period of outputting one frame of image; the green sub-pixels 13 and the red sub-pixels 12 in the pixel units are driven to display in the second period of outputting the one frame of image; and the first period is not overlapped with the second period. In order to ensure smooth images, the sum of the durations of the first period and the second period is equal to the duration of outputting one frame of image. Thus, in the process of displaying a dynamic image, the display time and the display images of two adjacent rows of pixel units can be better connected, so that the sense of mesh division can be avoided.

Moreover, in the case where the blue sub-pixel 11 and the green sub-pixel 13 share one compensating circuit, when the OLED pixel structure as illustrated in FIG. 6 is driven, the green sub-pixels 13 in the pixel units are driven to display in the first period of outputting one frame of image; the blue sub-pixels 11 and the red sub-pixels 12 in the pixel units are driven to display in the second period of outputting the one frame of image; and the first period is not overlapped with the second period. In order to ensure smooth images, the sum of the durations of the first period and the second period is equal to the duration of outputting one frame of image. Thus, in the process of displaying a dynamic image, the display time and the display images of two adjacent rows of pixel units can be better connected, so that the sense of mesh division can be avoided.

Moreover, in the case the blue sub-pixel 11 and the red sub-pixel 12 share one compensating circuit, when the OLED pixel structure as illustrated in FIG. 6 is driven, the blue sub-pixels 11 in the pixel units are driven to display in the first period of outputting one frame of image; the green sub-pixels 13 and the red sub-pixels 12 in the pixel units are driven to display in the second period of outputting the one frame of image; and the first period is not overlapped with the second period. In order to ensure smooth images, the sum of the durations of the first period and the second period is equal to the duration of outputting one frame of image. Thus, in the process of displaying a dynamic image, the display time and the display images of two adjacent rows of pixel units can be better connected, so that the sense of mesh division can be avoided.

### Sixth Embodiment

As illustrated in FIG. 4, the OLED pixel structure provided by the embodiment comprises a plurality of pixel units arranged in a matrix. Each pixel unit includes a blue sub-pixel 1, a red sub-pixel 2 and a green sub-pixel 3 arranged in the delta shape or in the inverted delta shape. In the display process, two adjacent pixel units share the red sub-pixel 2 or the blue sub-pixel 1, and the positions of the red sub-pixel 2 and the blue sub-pixel 1 may be exchanged. There are two means for two sub-pixels to share one compensating circuit: for instance, the green sub-pixel 3 and the red sub-pixel 2 share one compensating circuit, or the green sub-pixel 3 and the blue sub-pixel 1 share one compensating circuit. Thus, the problem of difficult layout of the OLED display device of high resolution can be solved.

In the case where the red sub-pixel 2 and the green sub-pixel 3 share one compensating circuit, as illustrated in FIG. 5, when the OLED pixel structure as illustrated in FIG. 4 is driven, the green sub-pixels 3 and the blue sub-pixels 1 in the pixel units are driven to display in the first period of outputting one frame of image; the red sub-pixels 2 in the pixel units are driven to display in the second period of outputting the one frame of image; and the first period is not overlapped with the second period. In order to ensure smooth images, the sum of the durations of the first period and the second period is equal to the duration of outputting one frame of image. Thus, in the process of displaying a dynamic image, the display time and the display images of two adjacent rows of pixel units can be better connected, so that the sense of mesh division can be avoided.

Moreover, in the case where the red sub-pixel 2 and the green sub-pixel 3 share one compensating circuit, when the OLED pixel structure as illustrated in FIG. 4 is driven, the red sub-pixels 2 and the blue sub-pixels 1 in the pixel units are driven to display in the first period of outputting one frame of image; the green sub-pixels 3 in the pixel units are driven to display in the second period of outputting the one frame of image; and the first period is not overlapped with the second period. In order to ensure smooth images, the sum of the durations of the first period and the second period is equal to the duration of outputting one frame of image. Thus, in the process of displaying a dynamic image, the display time and the display images of two adjacent rows of pixel units can be better connected, so that the sense of mesh division can be avoided.

Moreover, in the case where the blue sub-pixel 1 and the green sub-pixel 3 share one compensating circuit, when the OLED pixel structure as illustrated in FIG. 4 is driven, the green sub-pixels 3 and the red sub-pixels 2 in the pixel units are driven to display in the first period of outputting one frame of image; the blue sub-pixels 1 in the pixel units are driven to display in the second period of outputting the one frame of image; and the first period is not overlapped with the second period. In order to ensure smooth images, the sum of the durations of the first period and the second period is equal to the duration of outputting one frame of image. Thus, in the process of displaying a dynamic image, the display time and the display images of two adjacent rows of pixel units can be better connected, so that the sense of mesh division can be avoided.

Moreover, in the case where the blue sub-pixel 1 and the green sub-pixel 3 share one compensating circuit, when the OLED pixel structure as illustrated in FIG. 4 is driven, the blue sub-pixels 1 and the red sub-pixels 2 in the pixel units are driven to display in the first period of outputting one frame of image; the green sub-pixels 3 in the pixel units are driven to display in the second period of outputting the one frame of image; and the first period is not overlapped with the second period. In order to ensure smooth images, the sum of the durations of the first period and the second period is equal to the duration of outputting one frame of image. Thus, in the process of displaying a dynamic image, the display time and the display images of two adjacent rows of pixel units can be better connected, so that the sense of mesh division can be avoided.

In the embodiment of the present disclosure, the compensating circuit applied in the pixel unit may adopt any proper compensating circuit for OLED, as long as the compensating circuit can compensate the image nonuniformity caused by the parameter variation of driving thin-film transistors (TFTs) in the OLED driving circuit and the IR drop on a power wire; the compensating circuit may adopt any of current compensation type, voltage compensation type or mixed compensation type; and the sub-pixels in the pixel units may have independent OLED driving circuits. Different sub-pixels sharing one compensating circuit are respectively displayed in different period of outputting one frame of image. Specifically, the sub-pixels may be respectively controlled by switching TFTs. For instance, as for a 2T1C compensating circuit, a switching TFT may be additionally arranged between an output end of the compensating circuit and an input end of a luminescent device, so as to control the display of different sub-pixels sharing one compensating circuit in different periods of one frame.

What are described above is related to the illustrative embodiments of the disclosure only and not limitative to the scope of the disclosure; the scopes of the disclosure are defined by the accompanying claims.

The application claims priority to the Chinese patent application No. 201510673840.9, filed October 16, 2015, the entire disclosure of which is incorporated herein by reference as part of the present application.

## Claims

1. An organic light-emitting diode (OLED) pixel structure, comprising a plurality of pixel units arranged in a matrix,
wherein each pixel unit includes a plurality of sub-pixels with different colors; at least two sub-pixels in each pixel unit share one compensating circuit; and different sub-pixels sharing the same one compensating circuit are respectively displayed in different periods of outputting one frame of image.

2. The OLED pixel structure according to claim 1, wherein the pixel unit includes a first sub-pixel, a second sub-pixel and a third sub-pixel with different colors.

3. The OLED pixel structure according to claim 2, wherein the first sub-pixel, the second sub-pixel and the third sub-pixel are disposed in a same row; and the first sub-pixel and the second sub-pixel share the same one compensating circuit.

4. The OLED pixel structure according to claim 2, wherein the first sub-pixel, the second sub-pixel and the third sub-pixel are arranged in a delta shape or in an inverted delta shape;
the first sub-pixel and the second sub-pixel, and the third sub-pixel are disposed in different rows; and the first sub-pixel and the third sub-pixel share the same one compensating circuit.

5. The OLED pixel structure according to any one of claims 2 to 4, wherein the first sub-pixel, the second sub-pixel and the third sub-pixel are respectively a red sub-pixel, a green sub-pixel and a blue sub-pixel, respectively.

6. A driving method of the OLED pixel structure according to any one of claims 1 to 5, comprising:
driving portion of sub-pixels in the pixel units to display in a first period of outputting one frame of image; and
driving remaining sub-pixels in the pixel units to display in a second period of outputting the one frame of image,
wherein the first period is not overlapped with the second period; and at least one sub-pixel driven in the first period and at least one sub-pixel driven in the second period share the same one compensating circuit.

7. The driving method of the OLED pixel structure according to claim 6, wherein in the case where a first sub-pixel, a second sub-pixel and a third sub-pixel in the pixel unit are disposed in a same row, and the first sub-pixel and the second sub-pixel share the same one compensating circuit,
the first sub-pixel in the pixel unit is driven to display in the first period of outputting one frame of image, and the second sub-pixel and the third sub-pixel in the pixel unit are driven to display in the second period of outputting the one frame of image; or
the first sub-pixel and the third sub-pixel in the pixel unit are driven to display in the first period of outputting one frame of image, and the second sub-pixel in the pixel unit is driven to display in the second period of outputting the one frame of image.

8. The driving method of the OLED pixel structure according to claim 6, wherein in the case where a first sub-pixel, a second sub-pixel and a third sub-pixel in the pixel unit are arranged in a delta shape or in an inverted delta shape, the first sub-pixel and the second sub-pixel, and the third sub-pixel being disposed in different rows, the first sub-pixel and the third sub-pixel sharing the same one compensating circuit,
the first sub-pixel and the second sub-pixel in the pixel unit are driven to display in the first period of outputting one frame of image, and the third sub-pixel in the pixel unit is driven to display in the second period of outputting the one frame of image; or
the third sub-pixel in the pixel unit is driven to display in the first period of outputting one frame of image, and the first sub-pixel and the second sub-pixel in the pixel unit are driven to display in the second period of outputting the one frame of image.

9. The driving method of the OLED pixel structure according to claim 6, wherein a sum of durations of the first period and the second period is equal to duration of outputting one frame of image.

10. A driving circuit of the OLED pixel structure according to any one of claims 1 to 5, comprising:
a first driving unit configured to drive portion of sub-pixels in the pixel units to display in the first period of outputting one frame of image; and
a second driving unit configured to drive remaining sub-pixels in the pixel units to display in the second period of outputting the one frame of image,
wherein the first period is not overlapped with the second period; and at least one sub-pixel driven in the first period and at least one sub-pixel driven in the second period share the same one compensating circuit.

11. A display device, comprising the OLED pixel structure according to any one of claims 1 to 5 and the driving circuit according to claim 10.
